# EUROPEAN PATENT APPLICATION

(11) **EP 4 561 324 A1**
(43) Date of publication of application: **28.05.2025**
(21) Application number: 24213579.6
(22) Date of filing: 18.11.2024
(51) Int. Cl.: H10K 71/00, H10K 59/124, H10K 59/80

(54) **DISPLAY DEVICE AND METHOD OF MANUFACTURING THE DISPLAY DEVICE**

(30) Priority: 21.11.2023 KR 20230162782
(71) Applicant: Samsung Display Co., Ltd., Yongin-si, Gyeonggi-do 17113 (KR)
(72) Inventor: CHAE, Seung-Yeon, Yongin-si (KR); KWON, Seungwook, Yongin-si (KR); AHN, Sangtae, Yongin-si (KR); YOON, Heechang, Yongin-si (KR)
(74) Representative: Marks & Clerk LLP

(57) **Abstract**

A display device according to an embodiment may include a substrate including a display area and a peripheral area outside the display area, a pixel circuit layer disposed in the display area on the substrate and including a thin film transistor and a plurality of insulating layers, a light emitting element layer disposed in the display area on the substrate and including a light emitting element electrically connected to the thin film transistor, an encapsulation layer disposed on the light emitting element layer, and a pattern part disposed in a portion of the peripheral area on the substrate. An upper surface of the pattern part may have an uneven structure.

## Description

### BACKGROUND

### 1. Field

Embodiments relate to a display device and a method of manufacturing the display device.

### 2. Description of the Related Art

A display device may be manufactured (or provided) through processes including forming a pixel circuit layer including a thin film transistor and the like, a light emitting element layer, and the like on a substrate. A protective film or the like may be used to protect the light emitting element layer during sequential manufacturing processes of the display device.

As the demand for display devices having various shapes has increased and there is a limit to protecting display devices of various shapes with protective films, owing to a limitation in processing the various shapes thereof, methods for effectively protecting the display devices during a display device manufacturing process are being studied.

### SUMMARY

Embodiments provide a display device with improved reliability.

Embodiments also provide a method of manufacturing a display device with improved reliability.

Additional features of the example embodiments will be set forth in the description which follows, and in part will be apparent from the description, or may be learned by practice of the example embodiments.

A display device according to an embodiment includes a substrate including a display area and a peripheral area outside the display area, a pixel circuit layer disposed in the display area on the substrate and including a thin film transistor and a plurality of insulating layers, a light emitting element layer disposed in the display area on the substrate and including a light emitting element electrically connected to the thin film transistor, an encapsulation layer disposed on the light emitting element layer, and a pattern part disposed in a portion of the peripheral area on the substrate. An upper surface of the pattern part has an uneven structure.

In an embodiment, the pattern part may include a plurality of protrusions spaced apart from each other and a groove defining the plurality of protrusions.

In an embodiment, a distance between adjacent protrusions among the plurality of protrusions may range from about 10 µm to about 50 µm.

In an embodiment, each of the protrusions may have a rectangular shape in a cross-sectional view.

In an embodiment, each of the protrusions may have a reverse taper shape in a cross-sectional view.

In an embodiment, a bottom surface of the groove may have an insulating property.

In an embodiment, the light emitting element may include a pixel electrode, an emission layer, and a common electrode. The common electrode may extend from the display area to the peripheral area. A portion of the pattern part may overlap a portion of the common electrode in the peripheral area.

In an embodiment, in an area where the portion of the pattern part overlaps the portion of the common electrode, a bottom surface of the groove may be spaced apart from an upper surface of the common electrode in an upward direction.

In an embodiment, the encapsulation layer may include a first inorganic encapsulation layer disposed on the light emitting element layer, an organic encapsulation layer disposed on the first inorganic encapsulation layer, and a second inorganic encapsulation layer disposed on the organic encapsulation layer. At least one insulating layer among the plurality of insulating layers included in the pixel circuit layer, the first inorganic encapsulation layer, and the second inorganic encapsulation layer may extend from the display area to the peripheral area. At least an uppermost layer of the at least one insulating layer may define the groove of the pattern part in the peripheral area.

In an embodiment, the pattern part may be disposed corresponding to a corner portion of the display area.

In an embodiment, the substrate further may include a pad area positioned at a side of the display area. The peripheral area may include a first peripheral area between the display area and the pad area and a second peripheral area spaced apart from the pad area. The pattern part may be disposed in the second peripheral area of the peripheral area.

In an embodiment, the pattern part may adjoin an edge of the substrate.

In an embodiment, the pattern part may be continuously disposed from a first virtual line to a second virtual line. The first virtual line may be spaced apart from the display area in an outward direction and may be positioned within the peripheral area. The second virtual line may be positioned at an edge of the substrate.

In an embodiment, the display device may further include a first dam part disposed in the peripheral area on the substrate, spaced apart from the display area in an outward direction, and surrounding the display area. The pattern part may overlap the first dam part.

In an embodiment, the display device may further include a crack prevention part disposed in the peripheral area on the substrate and spaced apart from the first dam part in the outward direction. The pattern part may further overlap the crack prevention part.

In an embodiment, the display device may further include a second dam part disposed in the peripheral area on the substrate and spaced apart from the crack prevention part in the outward direction. The pattern part may further overlap the second dam part.

In an embodiment, the display device may further include an anti-reflection member disposed on the encapsulation layer.

A method of manufacturing a display device includes forming a pixel circuit layer, a light emitting element layer, and an encapsulation layer on a mother substrate including a plurality of cell areas, forming a pattern part in a peripheral area of each of the cell areas, forming a protective layer by providing a protective layer resin on the encapsulation layer and the pattern part of each of the cell areas, obtaining a plurality of display panels by cutting along cutting lines defined along edges of each of the cell areas, and removing the protective layer from each of the display panels. Each of the cell areas includes a display area and the peripheral area outside the display area. An upper surface of the pattern part has an uneven structure.

In an embodiment, at least one insulating layer among a plurality of insulating layers included in the pixel circuit layer and at least one inorganic encapsulation layer included in the encapsulation layer may extend from the display area to the peripheral area. The forming the pattern part may include forming a plurality of protrusions and a groove defining the plurality of protrusions by partially etching the at least one insulating layer in the peripheral area.

In an embodiment, the forming the protective layer may include curing the protective layer resin by exposing the provided protective layer resin to ultraviolet light.

In an embodiment, the forming the protective layer may include providing the protective layer resin such that an edge of the protective layer resin is positioned on the pattern part.

In an embodiment, the method may further include providing an anti-reflection member on each of the display panels from which the protective layer has been removed.

At least some of the above and other features of the invention are set out in the claims.

Embodiments of the present disclosure support preventing the protective layer, which is formed on the display panel and removed later during the manufacturing process of the display device, from remaining or reducing the remaining amount of the protective layer. Accordingly, a reliability of the display device may be improved.

It is to be understood that both the foregoing general description and the following detailed description are examples and explanatory and are intended to provide further explanation of the embodiments of the present disclosure as claimed.

### BRIEF DESCRIPTION OF THE DRAWINGS

The accompanying drawings, which are included to provide a further understanding of aspects supported by the present disclosure and are incorporated in and constitute a part of this specification, illustrate embodiments supported by the present disclosure, and together with the description serve to explain the example aspects supported by the present disclosure.
FIG. 1 is a perspective view illustrating a display device according to an embodiment.
FIG. 2 is a cross-sectional view taken along line I-I' of FIG. 1.
FIG. 3 is a plan view illustrating an example of a display panel included in the display device of FIG. 1.
FIG. 4 is a plan view illustrating another example of a display panel included in the display device of FIG. 1.
FIG. 5 is a cross-sectional view taken along line II-II' of FIG. 3.
FIG. 6 is a cross-sectional view illustrating an example taken along line III-III' of FIG. 3.
FIG. 7 is a perspective view illustrating an example of area 'A' of FIG. 6.
FIG. 8 is a perspective view illustrating another example of area 'A' of FIG. 6.
FIG. 9 is a cross-sectional view illustrating another example taken along line III-III' of FIG. 3.
FIG. 10 is a cross-sectional view illustrating still another example taken along line III-III' of FIG. 3.
FIGS. 11 and 12 are cross-sectional views illustrating a display panel according to an embodiment.
FIGS. 13 and 14 are cross-sectional views illustrating a display panel according to an embodiment.
FIGS. 15 to 21 are drawings illustrating a method of manufacturing a display device according to an embodiment.

### DETAILED DESCRIPTION

Example aspects of the present disclosure now will be described more fully hereinafter with reference to the accompanying drawings, in which various embodiments are illustrated. Aspects supported by the present disclosure may, however, be embodied in many different forms, and should not be construed as limited to the embodiments set forth herein. Rather, the example embodiments are provided such that this disclosure will be thorough and complete, and will fully convey the scope of example aspects of the present disclosure to those skilled in the art. Like reference numerals refer to like elements throughout.

It will be understood that when an element is referred to as being related to another element such as being "on" another element, the element can be directly on the other element or intervening elements may be present therebetween. In contrast, when an element is referred to as being related to another element such as being "directly on" another element, there are no intervening elements present.

It will be understood that, although the terms "first," "second," "third," and the like may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, a reference number may indicate a singular element or a plurality of the element. For example, a reference number labeling a singular form of an element within the drawing figures may be used to reference a plurality of the singular element within the text of specification.

As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as, for example, "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can, therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of example embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Illustrative, non-limiting embodiments will be more clearly understood from the following detailed description in conjunction with the accompanying drawings.

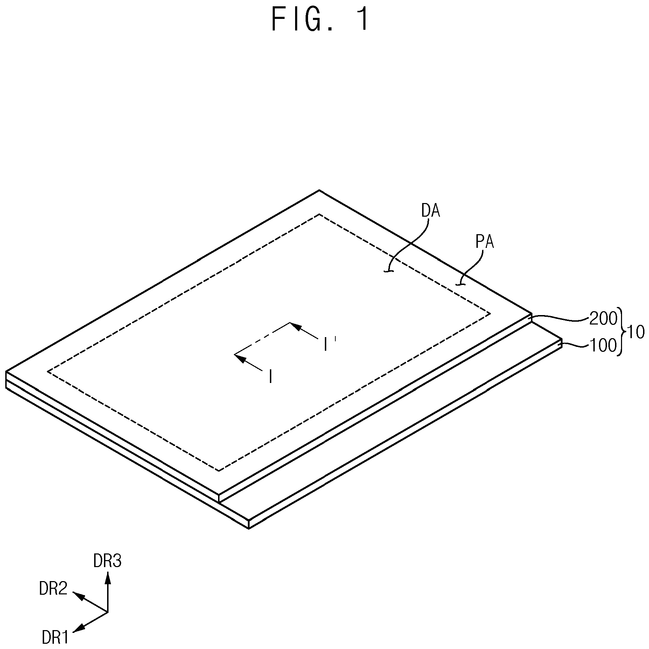

FIG. 1 is a perspective view illustrating a display device according to an embodiment.

Referring to FIG. 1, in an embodiment, a display device 10 may have a display surface defined by a first direction DR1 and a second direction DR2 crossing the first direction DR1. The display device 10 may display an image in a third direction DR3 through the display surface. The third direction DR3 may be substantially parallel to a normal direction of the display surface. The display surface may correspond to a front surface (or an upper surface) of the display device 10.

The display device 10 may include a display area DA and a peripheral area PA. The image may be displayed in the display area DA.

The peripheral area PA may be positioned around the display area DA. The peripheral area PA may be positioned outside the display area DA. For example, the peripheral area PA may surround the display area DA in a plan view.

The display device 10 may include a display panel 100 and an anti-reflection member 200. A plurality of pixels for generating the image may be disposed in the display area DA of the display panel 100.

Each of the pixels may include a pixel circuit and a light emitting element. The pixel circuit may include at least one thin film transistor and at least one capacitor. The thin film transistor may generate a driving current and provide the generated driving current to the light emitting element. The light emitting element may emit light based on the driving current. For example, the light emitting element may include an organic light emitting diode, an inorganic light emitting diode, a quantum dot light emitting diode, or the like. The image may be generated by combining light emitted from each of the pixels.

The anti-reflection member 200 may be disposed on the display panel 100. The anti-reflection member 200 may reduce a reflectance with respect to external light incident upon the anti-reflection member 200 from the outside of the display device 10. In other words, the anti-reflection member 200 may reduce the reflectance of the display device 10 with respect to the external light. The anti-reflection member 200 may include a polarizer, a retarder, a destructive interference structure, a plurality of color filters, or the like.

In an embodiment, a cover window (not illustrated) may be disposed on the anti-reflection member 200. The cover window may be transparent.

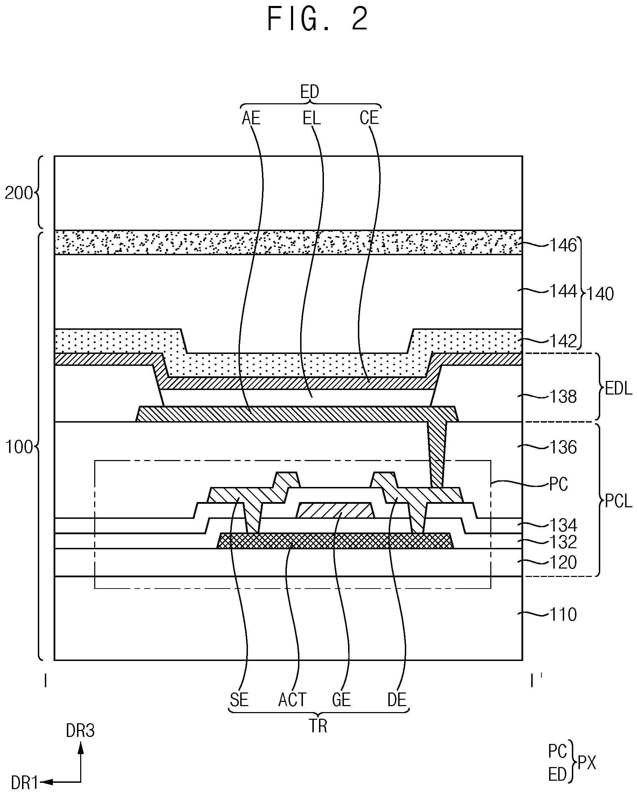

FIG. 2 is a cross-sectional view taken along line I-I' of FIG. 1.

Hereinafter, the display area DA of the display device 10 will be described in detail with reference to FIGS. 1 and 2.

Referring to FIGS. 1 and 2, in an embodiment, the display panel 100 includes a substrate 110, a pixel circuit layer PCL, a light emitting element layer EDL, and an encapsulation layer 140. The pixel circuit layer PCL may include the pixel circuit PC and a plurality of insulating layers 120, 132, 134, and 136. The pixel circuit PC may include at least one thin film transistor TR and at least one capacitor (not illustrated). The light emitting element layer EDL may include the light emitting element ED and a pixel defining layer 138. The light emitting element ED may include a pixel electrode AE, an emission layer EL, and a common electrode CE. The pixel circuit PC and the light emitting element ED may form the pixel PX. The anti-reflection member 200 may be disposed on the encapsulation layer 140.

The substrate 110 may be an insulating substrate including or formed of a transparent material or a non-transparent material. In an embodiment, the substrate 110 may be a rigid substrate including a material such as, for example, glass or quartz. In another embodiment, the substrate 110 may be a flexible substrate including plastic.

The buffer layer 120 may be disposed on the substrate 110. The buffer layer 120 may prevent or reduce impurities such as, for example, oxygen or moisture from penetrating into an upper portion of the substrate 110 through the substrate 110. The buffer layer 120 may include an inorganic material. In an embodiment, for example, the buffer layer 120 may include silicon oxide (SiO), silicon nitride (SiN), silicon oxynitride (SiON), silicon oxycarbide (SiOC), silicon carbonitride (SiCN), aluminium oxide (AlO), aluminium nitride (AlN), tantalum oxide (TaO), hafnium oxide (HfO), zirconium oxide (ZrO), titanium oxide (TiO), or the like. These can be used alone or in a combination thereof. The buffer layer 120 may have a single-layered structure or a multi-layered structure including a plurality of insulating layers.

The thin film transistor TR may be disposed on the buffer layer 120. The thin film transistor TR may include an active layer ACT, a gate electrode GE, a source electrode SE, and a drain electrode DE.

The active layer ACT may be disposed on the buffer layer 120. The active layer ACT may include an oxide semiconductor, a silicon semiconductor, an organic semiconductor, or the like. In an embodiment, for example, the oxide semiconductor may include at least one selected from oxides of indium (In), gallium (Ga), tin (Sn), zirconium (Zr), vanadium (V), hafnium (Hf), cadmium (Cd), germanium (Ge), chromium (Cr), titanium (Ti), and zinc (Zn). The silicon semiconductor may include an amorphous silicon, a polycrystalline silicon, or the like. The active layer ACT may include a source area, a drain area, and a channel area positioned between the source area and the drain area.

A gate insulating layer 132 may be disposed on the active layer ACT. The gate insulating layer 132 may cover the active layer ACT on the buffer layer 120. The gate insulating layer 132 may include an inorganic insulating material.

The gate electrode GE may be disposed on the gate insulating layer 132. The gate electrode GE may overlap the channel area of the active layer ACT. The gate electrode GE may include a conductive material such as, for example, a metal, an alloy, a conductive metal nitride, a conductive metal oxide, a transparent conductive material, or the like. In an embodiment, for example, the gate electrode GE may include gold (Au), silver (Ag), aluminium (Al), platinum

(Pt), nickel (Ni), titanium (Ti), palladium (Pd), magnesium (Mg), calcium (Ca), lithium (Li), chromium (Cr), tantalum (Ta), tungsten (W), copper (Cu), molybdenum (Mo), scandium (Sc), neodymium (Nd), iridium (Ir), alloys containing aluminium, alloys containing silver, alloys containing copper, alloys containing molybdenum, aluminium nitride (AlN), tungsten nitride (WN), titanium nitride (TiN), chromium nitride (CrN), tantalum nitride (TaN), strontium ruthenium oxide (SrRuO), zinc oxide (ZnO), indium tin oxide (ITO), tin oxide (SnO), indium oxide (InO), gallium oxide (GaO), indium zinc oxide (IZO), or the like. The materials can be used alone or in a combination thereof. The gate electrode GE may have a single-layered structure or a multi-layered structure including a plurality of conductive layers.

An interlayer insulating layer 134 may be disposed on the gate electrode GE. The interlayer insulating layer 134 may cover the gate electrode GE on the gate insulating layer 132. The interlayer insulating layer 134 may include an inorganic insulating material.

The source electrode SE and the drain electrode DE may be disposed on the interlayer insulating layer 134. The source electrode SE and the drain electrode DE may be connected to the source area and the drain area of the active layer ACT, respectively. Each of the source electrode SE and the drain electrode DE may include a conductive material.

A via insulating layer 136 may be disposed on the source electrode SE and the drain electrode DE. The via insulating layer 136 may include an organic insulating material. In an embodiment, for example, the via insulating layer 136 may include photoresist, polyacryl-based resin, polyimide-based resin, polyamide-based resin, siloxane-based resin, acryl-based resin, epoxy-based resin, or the like. The materials can be used alone or in a combination thereof.

FIG. 2 illustrates that the pixel circuit layer PCL includes four insulating layers and three conductive layers, but this is an example, and embodiments are not limited thereto. For example, the pixel circuit layer PCL may include five or more insulating layers and four or more conductive layers.

A pixel electrode AE may be disposed on the via insulating layer 136. The pixel electrode AE may include a conductive material. The pixel electrode AE may have a single-layered structure or a multi-layered structure including a plurality of conductive layers. The pixel electrode AE may be connected to the drain electrode DE through a contact hole defined or formed in the via insulating layer 136. Accordingly, the pixel electrode AE may be electrically connected to the thin film transistor TR.

The pixel defining layer 138 may be disposed on the pixel electrode AE. The pixel defining layer 138 may cover a peripheral portion of the pixel electrode AE, and the pixel defining layer 138 may define a pixel opening exposing a central portion of the pixel electrode AE. The pixel defining layer 138 may include an organic insulating material.

The emission layer EL may be disposed on the pixel electrode AE. The emission layer EL may be disposed in the pixel opening of the pixel defining layer 138. In some embodiments, the emission layer EL may include at least one of an organic light emitting material or quantum dot.

In an embodiment, the organic light emitting material may include a low molecular weight organic compound or a high molecular weight organic compound. Examples of the low molecular weight organic compound may include copper phthalocyanine, N,N'-diphenylbenzidine, tris-(8-hydroxyquinoline)aluminium, or the like. Examples of the high molecular weight organic compound may include poly(3,4-ethylenedioxythiophene), polyaniline, poly-phenylenevinylene, polyfluorene, or the like. The materials can be used alone or in a combination thereof.

In an embodiment, the quantum dot may include a core including a Group II-VI compound, a Group III-V compound, a Group IV-VI compound, a Group IV element, and/or a Group IV compound. In an embodiment, the quantum dot may have a core-shell structure including the core and a shell surrounding the core. The shell may serve as a protection layer for preventing the core from being chemically denatured to maintain semiconductor characteristics, and the shell may serve as a charging layer for imparting electrophoretic characteristics to the quantum dot.

The common electrode CE may be disposed on the emission layer EL. The common electrode CE may also be disposed on the pixel defining layer 138. The common electrode CE may include a conductive material. The pixel electrode AE, the emission layer EL, and the common electrode CE may form the light emitting element ED. The light emitting element ED may further include various functional layers (e.g., a hole injection layer, a hole transport layer, an electron transport layer, an electron injection layer, or the like) disposed between the pixel electrode AE and the emission layer EL or between the emission layer EL and the common electrode CE.

The encapsulation layer 140 may be disposed on the common electrode CE. The encapsulation layer 140 may include at least one inorganic encapsulation layer and at least one organic encapsulation layer. In an embodiment, the encapsulation layer 140 may include a first inorganic encapsulation layer 142 disposed on the common electrode CE, an organic encapsulation layer 144 disposed on the first inorganic encapsulation layer 142, and a second inorganic encapsulation layer 146 disposed on the organic encapsulation layer 144. The organic encapsulation layer 144 may cover the entire display area DA. In some aspects, although not illustrated in the drawing, the display panel 100 may further include various functional layers (e.g., a touch sensing layer, a color filter layer, a light collecting layer, or the like) disposed on the encapsulation layer 140.

The anti-reflection member 200 may be disposed on the display panel 100. The anti-reflection member 200 may be disposed on the encapsulation layer 140. The anti-reflection member 200 may be disposed on the second inorganic encapsulation layer 146. For example, the anti-reflection member 200 may be attached to the display panel 100 through an adhesive member. The adhesive member may include an optical clear adhesive ("OCA"), a pressure sensitive adhesive ("PSA"), a photocurable resin, a thermosetting resin, or the like.

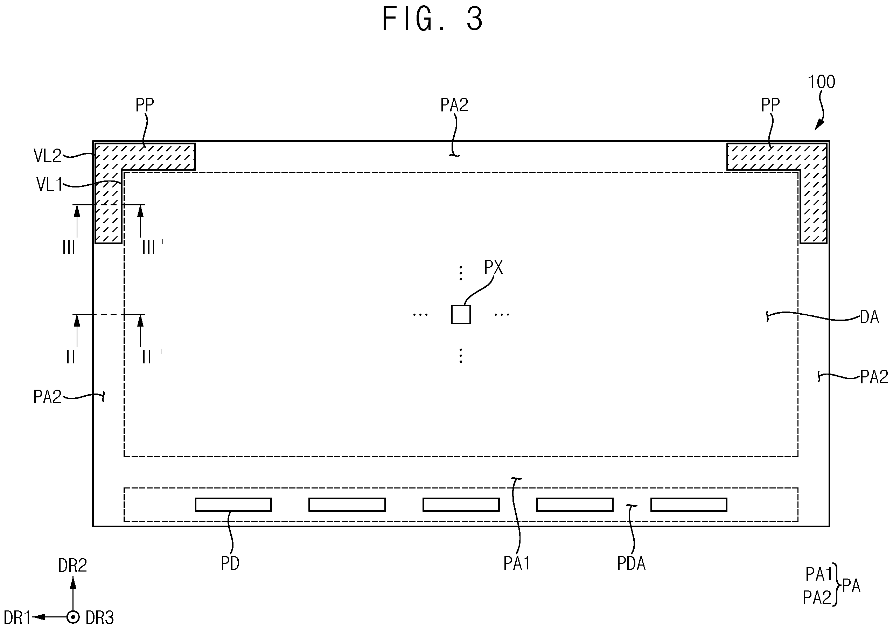

FIG. 3 is a plan view illustrating an example of a display panel 100 included in the display device 10 of FIG. 1.

Referring to FIGS. 1 and 3, the display panel 100 may include the display area DA, the peripheral area PA, and a pad area PDA. The plurality of pixels PX may be disposed in the display area DA. For example, the pixels PX may be arranged in a matrix form along the first direction DR1 and the second direction DR2.

The peripheral area PA may be positioned outside the display area DA. For example, the peripheral area PA may surround the display area DA in a plan view.

The pad area PDA may be positioned at at least one side of the display area DA. The pad area PDA may be spaced apart from the display area DA. A pad unit PD electrically connected to a driver (e.g., a data driver, a scan driver, or the like) may be disposed in the pad area PDA. The driver may provide various driving signals (e.g., a driving voltage, a gate signal, a data signal, or the like) for driving the pixels PX to the display area DA. FIG. 3 illustrates that the pad area PDA is positioned only at a side of the display area DA, but this is an example, and embodiments are not limited thereto. For example, the pad area PDA may be additionally positioned in other areas outside the display area DA.

The peripheral area PA may include a first peripheral area PA1 and a second peripheral area PA2. The first peripheral area PA1 may be an area positioned between the display area DA and the pad area PDA. The second peripheral area PA2 may be positioned outside the display area DA and spaced apart from the pad area PDA. For example, the second peripheral area PA2 may refer to a remainder of the peripheral area PA surrounding the display area DA different from the first peripheral area PA1 between the display area DA and the pad area PDA. Specifically, in FIG. 3, the first peripheral area PA1 may be an area adjacent to a lower side of the display area DA, and the second peripheral area PA2 may be an area adjacent to left, upper, and right sides of the display area DA.

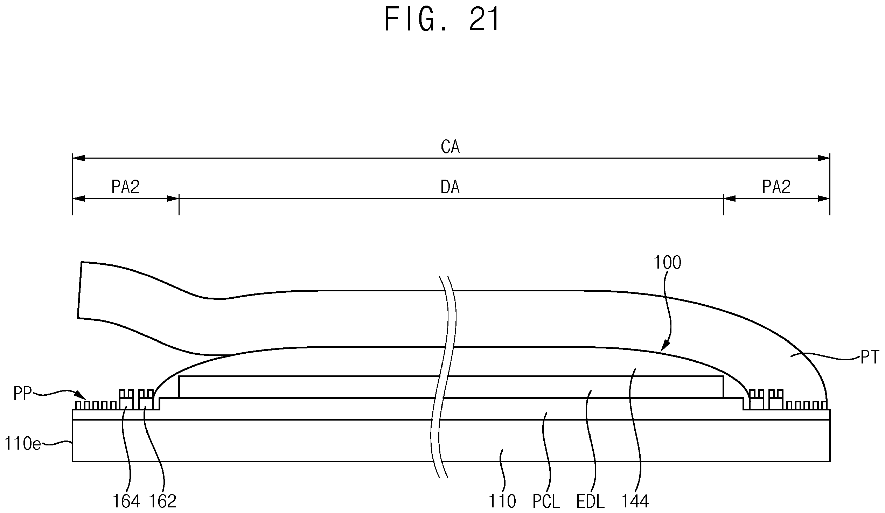

The display panel 100 includes a pattern part PP disposed in the peripheral area PA. The pattern part PP is a structure whose upper surface has an uneven structure (e.g. a concavo-convex structure). With respect to a protective layer formed on and later to be removed from the display panel 100 (refer to FIG. 21), aspects of the pattern part PP support relatively easy removal of the protective layer. Aspects of the pattern part PP and removal of the protective layer will be described in detail later.

The pattern part PP is disposed in a portion of the peripheral area PA. In an embodiment, the pattern part PP may be disposed in the second peripheral area PA2 of the peripheral area PA. For example, the pattern part PP may be disposed only in the second peripheral area PA2 of the peripheral area PA, excluding the first peripheral area PA1.

In an embodiment, as illustrated in FIG. 3, the pattern part PP may be disposed in a portion of the second peripheral area PA2 corresponding to a corner portion of the display area DA. For example, the pattern part PP may be disposed only in the portion of the second peripheral area PA2 corresponding to the corner portion of the display area DA. In an example, the pattern part PP may be disposed corresponding to each of two corner portions (upper left corner and upper right corner of FIG. 3) that are not adjacent to the pad area PDA among four corner portions of the display area DA. However, this is an example and embodiments are not limited thereto, and the pattern part PP may be disposed corresponding to at least one of the four corner portions of the display area DA.

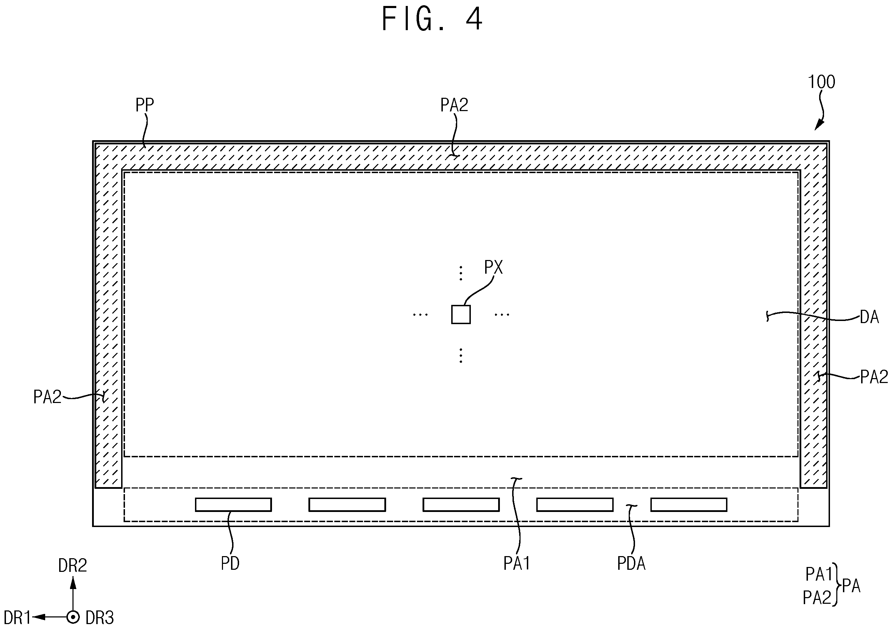

FIG. 4 is a plan view illustrating another example of a display panel 100 included in the display device 10 of FIG. 1.

Referring to FIG. 4, in an embodiment, the pattern part PP may be substantially entirely disposed in the second peripheral area PA2 corresponding to an edge of the display area DA. For example, the pattern part PP may be disposed corresponding to left, upper and right edges that are not adjacent to the pad area PDA among edges of the display area DA.

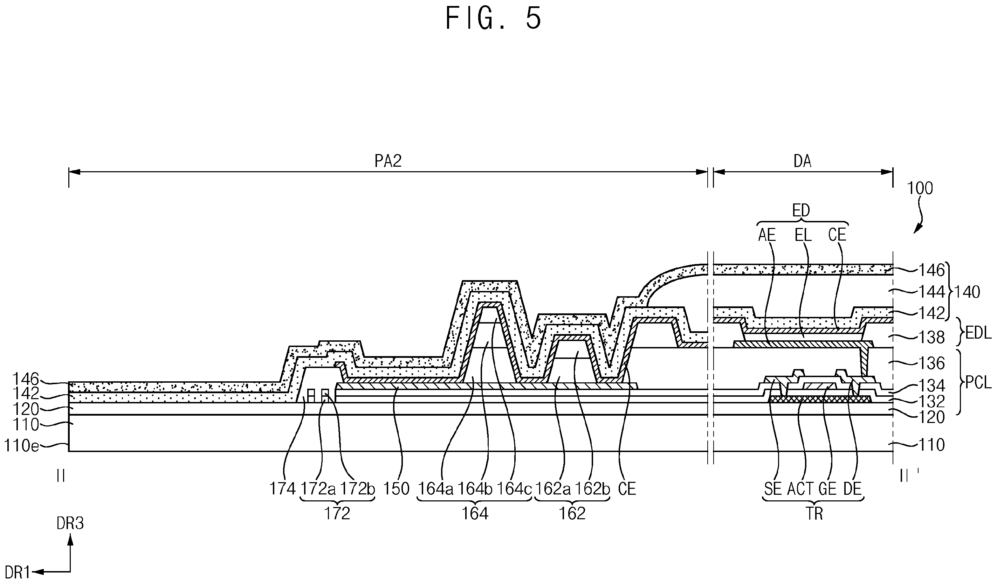

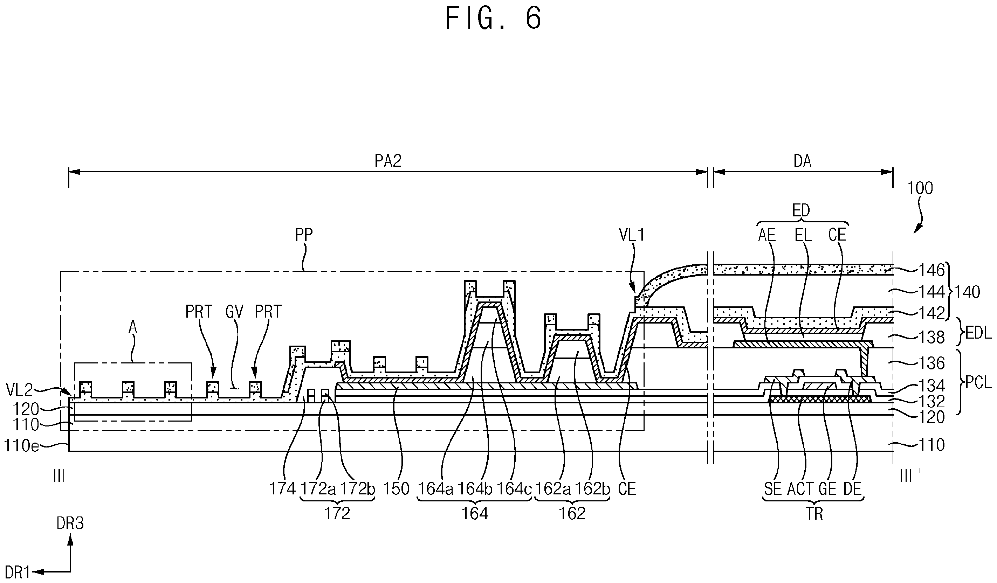

FIG. 5 is a cross-sectional view taken along line II-II' of FIG. 3. FIG. 6 is a cross-sectional view illustrating an example taken along line III-III' of FIG. 3.

Hereinafter, the peripheral area PA of the display panel 100 will be described in detail with reference to FIGS. 5 and 6.

For example, FIG. 5 illustrates an example of a portion of the second peripheral area PA2 where the pattern part PP is not disposed, and FIG. 6 illustrates an example of a portion of the second peripheral area PA2 where the pattern part PP is disposed. First, the portion of the second peripheral area PA2 where the pattern part PP is not disposed will be described with reference to FIG. 5.

Referring to FIGS. 3 and 5, the display panel 100 may further include a power transmission line 150, a first dam part 162, a second dam part 164, and a crack prevention part 172 disposed in the peripheral area PA.

At least one insulating layer among the insulating layers included in the pixel circuit layer PCL and the inorganic encapsulation layers included in the encapsulation layer 140 described with reference to FIG. 2 may extend from the display area DA to the peripheral area PA including the second peripheral area PA2. In other words, at least one insulating layer among the buffer layer 120, the gate insulating layer 132, the interlayer insulating layer 134, the via insulating layer 136, the first inorganic encapsulation layer 142, and the second inorganic encapsulation layer 146 may extend from the display area DA to the peripheral area PA. For example, as illustrated in FIG. 5, the buffer layer 120, the first inorganic encapsulation layer 142, and the second inorganic encapsulation layer 146 may extend to an edge 110e of the substrate 110, and the gate insulating layer 132 and the interlayer insulating layer 134 may extend to the crack prevention part 172 between the display area DA and the edge 110e of the substrate 110. However, this is an example and embodiments are not limited thereto, and the arrangement structure of the insulating layers in the peripheral area PA may be variously modified.

The power transmission line 150 may be disposed in the peripheral area PA on the substrate 110. For example, the power transmission line 150 may be disposed in the second peripheral area PA2 on the substrate 110. The power transmission line 150 may be spaced apart from the display area DA in an outward direction.

In an embodiment, the common electrode CE included in the light emitting element layer EDL described with reference to FIG. 2 may extend from the display area DA to the second peripheral area PA2. For example, the common electrode CE may extend to the crack prevention part 172. A portion of the common electrode CE extending to the second peripheral area PA2 may be electrically connected to the power transmission line 150. Accordingly, the common electrode CE can receive a low power voltage ("ELVSS") from the power transmission line 150.

The first dam part 162 may be disposed in the peripheral area PA on the substrate 110. The first dam part 162 may be disposed in the first peripheral area PA1 and the second peripheral area PA2 on the substrate 110. For example, in a plan view, the first dam part 162 may be spaced apart from the display area DA in the outward direction, and the first dam part 162 may have a shape that substantially entirely surrounds the display area DA. In some embodiments, the first dam part 162 may be discontinuous in some sections.

The second dam part 164 may be disposed in the peripheral area PA on the substrate 110. The second dam part 164 may be disposed in the first peripheral area PA1 and the second peripheral area PA2 on the substrate 110. For example, in a plan view, the second dam part 164 may be spaced apart from the first dam part 162 in the outward direction, and the second dam part 164 may have a shape that substantially entirely surrounds the first dam part 162. In some embodiments, the second dam part 164 may be discontinuous in some sections.

Each of the first dam part 162 and the second dam part 164 may have a multi-layer structure including a plurality of layers. For example, as illustrated in FIG. 5, the first dam part 162 may include a first layer 162a and a second layer 162b, and the second dam part 164 may include a first layer 164a, a second layer 164b, and a third layer 164c. For example, the first layer 162a of the first dam part 162 and the first layer 164a of the second dam part 164 may be substantially simultaneously formed with the via insulating layer 136 of the display area DA. The second layer 162b of the first dam part 162 and the second layer 164b of the second dam part 164 may be substantially simultaneously formed with the pixel defining layer 138 of the display area DA. The third layer 164c of the second dam part 164 may be substantially simultaneously formed with a spacer (not illustrated) of the display area DA. However, this is an example and embodiments are not limited thereto.

The first dam part 162 and the second dam part 164 may prevent the organic encapsulation layer 144, which is disposed in the display area DA and encapsulates the light emitting element layer EDL, from overflowing. For example, the first dam part 162 and the second dam part 164 may prevent the organic encapsulation layer 144 from overflowing to unintended portions of the display panel 100 during formation of the organic encapsulation layer 144.

The crack prevention part 172 may be disposed in the peripheral area PA on the substrate 110. For example, the crack prevention part 172 may be disposed in the first peripheral area PA1 and the second peripheral area PA2 on the substrate 110. For example, in a plan view, the crack prevention part 172 may be spaced apart from the second dam part 164 in the outward direction, and the crack prevention part 172 may have a shape that substantially entirely surrounds the second dam part 164. In some embodiments, the crack prevention part 172 may be discontinuous in some sections.

The crack prevention part 172 may include at least one inorganic insulating layer. The crack prevention part 172 may be spaced apart from at least one insulating layer extending to the peripheral area PA including the second peripheral area PA2 among the inorganic insulating layers included in the pixel circuit layer PCL in the outward direction. For example, as illustrated in FIG. 5, the gate insulating layer 132 and the interlayer insulating layer 134 may extend from the display area DA to the peripheral area PA. The crack prevention part 172 may be spaced apart from the gate insulating layer 132 and the interlayer insulating layer 134 extending to the peripheral area PA in the outward direction. For example, the crack prevention part 172 may be formed by partially removing the gate insulating layer 132 and the interlayer insulating layer 134. That is, a first layer 172a of the crack prevention part 172 may be substantially simultaneously formed with the gate insulating layer 132, and a second layer 172b of the crack prevention part 172 may be substantially simultaneously formed with the interlayer insulating layer 134. For example, as illustrated in FIG. 5, a plurality of crack prevention parts 172 may be provided.

In an embodiment, a cover layer 174 may be disposed on the crack prevention part 172. The cover layer 174 may cover the crack prevention part 172, and the cover layer 174 may fill a transfer prevention groove formed at at least one side of the crack prevention part 172. The cover layer 174 may include an organic insulating material. For example, the cover layer 174 may be substantially simultaneously formed with the via insulation layer 136 of the display area DA.

In an embodiment, the first inorganic encapsulation layer 142 and the second inorganic encapsulation layer 146 may extend from the display area DA to the peripheral area PA including the second peripheral area PA2. For example, the first inorganic encapsulation layer 142 and the second inorganic encapsulation layer 146 may extend to the edge 110e of the substrate 110. In the peripheral area PA, the first inorganic encapsulation layer 142 and the second inorganic encapsulation layer 146 may cover the common electrode CE, the first dam part 162, the second dam part 164, and the cover layer 174.

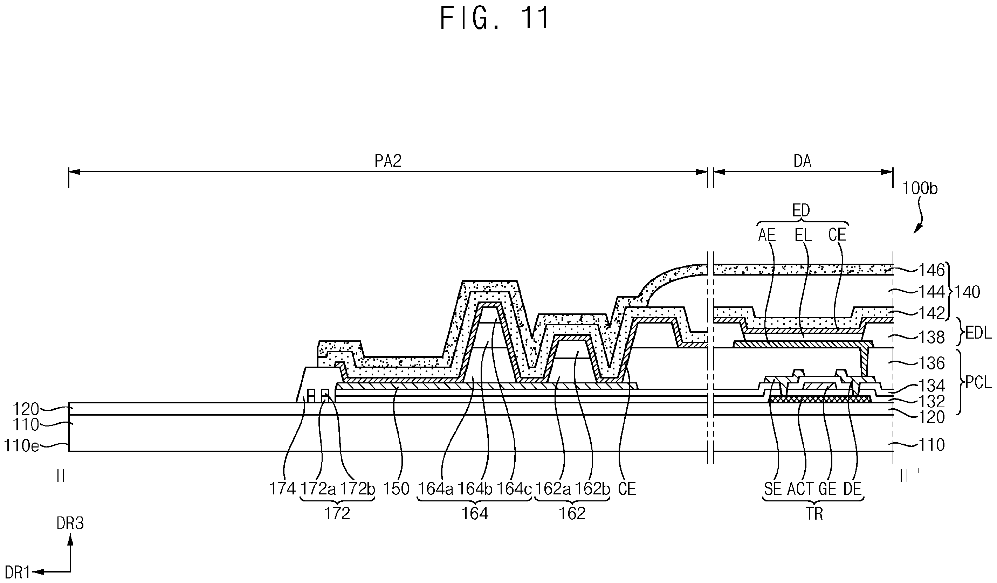

In some embodiments, FIG. 5 illustrates that the second inorganic encapsulation layer 146 is an uppermost layer of the display panel 100 in the second peripheral area PA2, but this is an example and embodiments are not limited thereto. For example, in at least a portion of the second peripheral area PA2, the second inorganic encapsulation layer 146 may be omitted, and another insulating layer disposed below the second inorganic encapsulation layer 146 may be the uppermost layer (refer to FIG. 11). In another example, in at least a portion of the second peripheral area PA2, another insulating layer (e.g., a touch insulating layer, or the like) disposed above the second inorganic encapsulation layer 146 may be the uppermost layer.

Next, a portion of the second peripheral area PA2 where the pattern part PP is disposed will be described with reference to FIG. 6.

Referring to FIGS. 3 and 6, the pattern part PP of the display panel 100 may be disposed in a portion of the second peripheral area PA2 on the substrate 110. The pattern part PP is a structure whose upper surface has an uneven structure.

The pattern part PP may be formed by partially removing at least one insulating layer extending to the second peripheral area PA2. In other words, an upper portion of an insulating structure positioned in the second peripheral area PA2 and including at least one insulating layer may be partially removed, and a portion of the insulating structure whose upper surface has an uneven structure by the partially removing may be defined as the pattern part PP. For example, FIG. 6 illustrates that a portion of an upper portion of an insulating structure including the first inorganic encapsulation layer 142 and the second inorganic encapsulation layer 146 is removed to form the pattern part PP in the second peripheral area PA2, but this is an example and embodiments are not limited thereto.

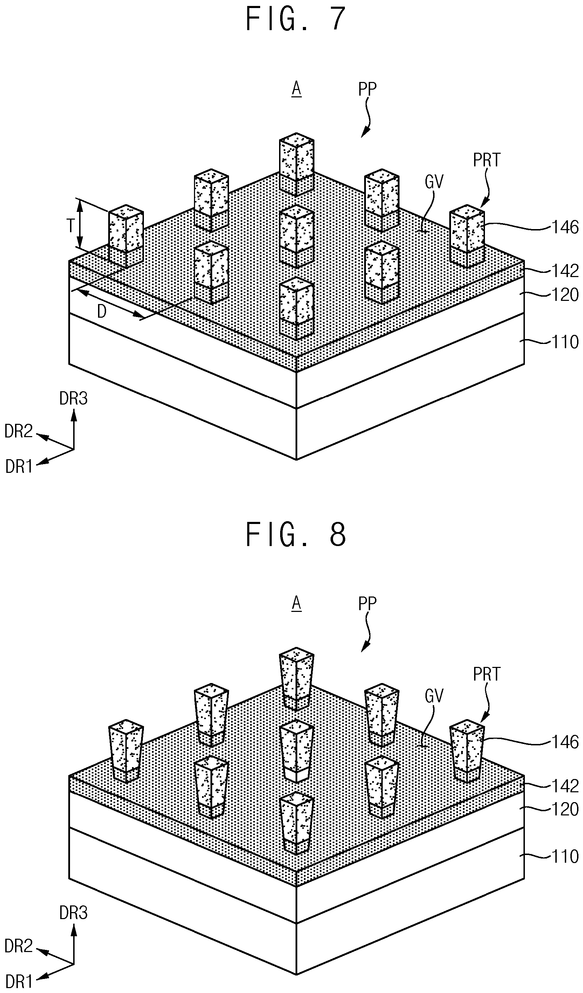

FIG. 7 is a perspective view illustrating an example of area 'A' of FIG. 6.

Referring to FIGS. 6 and 7, the pattern part PP may have a plurality of protrusions PRT spaced apart from each other and a groove GV defining the protrusions PRT. For example, the protrusions PRT may be disposed such that the protrusions PRT are spaced apart from each other along the first direction DR1 and the second direction DR2. The groove GV may define the protrusions PRT. That is, in a plan view, the groove GV may surround each of the protrusions PRT. For example, a space where the portion of the upper portion of the insulating structure positioned in the second peripheral area PA2 is removed may be defined as the groove GV, and remaining portions of the insulating structure where the upper portion is not removed may be defined as the protrusions PRT. At least the upper most layer (e.g., the second inorganic encapsulation layer 146) among at least one insulating layer extending to the second peripheral area PA2 among the plurality of insulating layers included in the pixel circuit layer PCL and the inorganic encapsulation layers included in the encapsulation layer 140 may define the groove GV in the second peripheral area PA2.

With respect to the protective layer formed on and later to be removed from the display panel 100 (refer to FIG. 21), aspects of the pattern part PP support relatively easy removal of the protective layer. For example, the protective layer may be formed by providing a protective layer resin on the display panel 100 through inkjet printing process or the like, and curing the provided protective layer resin. The protective layer resin may be provided on the display panel 100 such that an edge of the protective layer resin is positioned on the pattern part PP. In this case, because the pattern part PP includes the protrusions PRT spaced apart from each other, a contact angle of the protective layer resin may be increased. That is, compared to a comparative example in which the pattern part PP is not formed, the protective layer in accordance with one or more embodiments of the present disclosure may be formed to have a relatively thick edge portion, and thus the protective layer can be easily removed from the display panel 100. Accordingly, embodiments of the present disclosure support preventing the protective layer from remaining on the display panel or reducing the amount of the protective layer which remains on the display panel, and a reliability of the display device 10 may be improved.

In an embodiment, a distance D between the adjacent protrusions PRT may range from about 10 µm to about 50 µm. If the distance D between the adjacent protrusions PRT is less than about 10 µm, the effect of improving the contact angle of the protective layer resin may not be achievable. If the distance D between the adjacent protrusions PRT is greater than about 50 µm, the effect of improving the contact angle of the protective layer resin may be reduced. Accordingly, the distance D between the adjacent protrusions PRT may range from about 10 µm to about 50 µm. Preferably, for example, the distance D between the adjacent protrusions PRT may range from about 25 µm to about 50 µm.

In an embodiment, as illustrated in FIG. 7, each of the protrusions PRT may have a rectangular shape in a cross-sectional view. For example, the portion of the upper portion of the insulating structure positioned in the second peripheral area PA2 may be removed by dry etching. In this case, each of the protrusions PRT may have a substantially rectangular shape in a cross-sectional view.

FIG. 8 is a perspective view illustrating another example of area 'A' of FIG. 6.

Referring to FIG. 8, in an embodiment, each of the protrusions PRT may have a reverse taper shape where an upper side is larger (e.g., wider in the first direction DR1 and/or second direction DR2) than a lower side in a cross-sectional view. That is, the groove GV may have an undercut shape in a cross-sectional view. In an example in which each of the protrusions PRT has a reverse taper shape in a cross-sectional view, the effect of improving the contact angle of the protective layer resin may be further increased. For example, each of the protrusions PRT may be formed to have a reverse taper shape in a cross-sectional view by appropriately adjusting conditions for the dry etching process. In another example, the portion of the upper portion of the insulating structure positioned in the second peripheral area PA2 may be removed by wet etching.

Referring again to FIGS. 6 and 7, embodiments of the present disclosure support variously determining or setting a thickness T of each of the protrusions PRT. The thickness T of the protrusion PRT may be defined as a distance between an upper surface of the protrusion PRT and a bottom surface of the groove GV. That is, the thickness T of the protrusion PRT may be equal to a depth of the groove GV Accordingly, for example, for cases in which the portion of the upper portion of the insulating structure positioned in the second peripheral area PA2 is removed, the insulating structure may not expose a conductive layer (e.g., the common electrode CE of FIG. 6) that can be disposed below the insulating structure.

That is, in the second peripheral area PA2, even if the portion of the upper portion of the insulating structure is removed to form the pattern part PP, the conductive layer can be disposed below and covered by the pattern part PP.

The bottom surface of the groove GV may have an insulating property. In other words, the bottom surface of the groove GV may be a portion of an insulating layer extending to the second peripheral area PA2. For example, as illustrated in FIG. 6, the bottom surface of the groove GV may be a portion of the first inorganic encapsulation layer 142 extending to the second peripheral area PA2, but this is an example and embodiments are not limited thereto.

The pattern part PP may overlap at least one conductive layer disposed in the second peripheral area PA2 in the third direction DR3. For example, as illustrated in FIG. 6, a portion of the pattern part PP may overlap a portion of the common electrode CE positioned in the second peripheral area PA2 in the third direction DR3. In the area where the portion of the pattern part PP overlaps the portion of the common electrode CE, the bottom surface of the groove GV may be spaced apart from an upper surface of the common electrode CE in the third direction DR3, which is an upper direction. That is, the common electrode CE may be covered by the pattern part PP. Accordingly, the pattern part PP may prevent or reduce impurities such as, for example, oxygen or moisture from penetrating into the common electrode CE.

In an embodiment, as illustrated in FIG. 6, the thickness of each of the protrusions PRT may be greater than a thickness of the second inorganic encapsulation layer 146, and the thickness of each of the protrusions PRT may be less than a sum of a thickness of the first inorganic encapsulation layer 142 and the thickness of the second inorganic encapsulation layer 146. In this case, the bottom surface of the groove GV may be a portion of the first inorganic encapsulation layer 142 extending to the second peripheral area PA2.

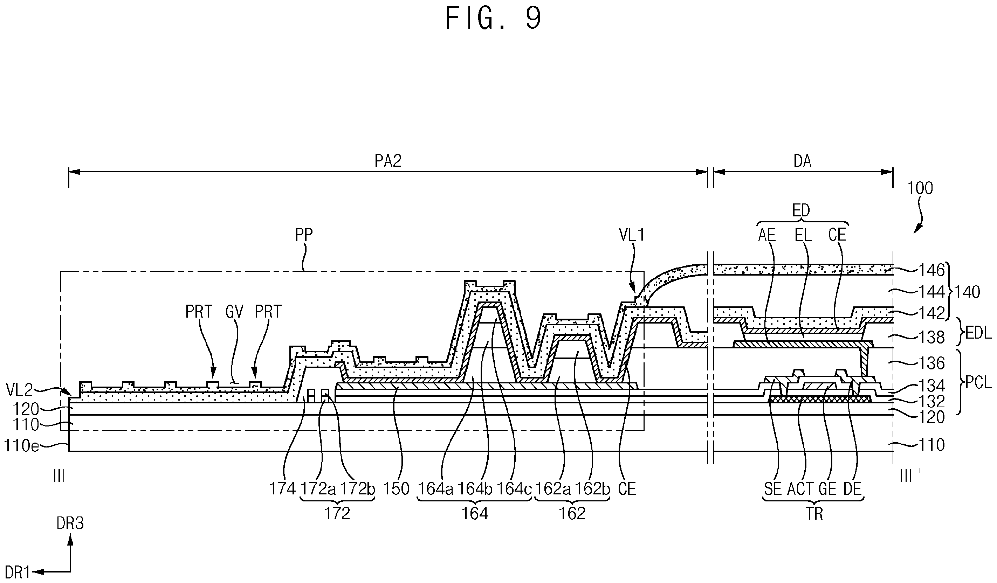

FIG. 9 is a cross-sectional view illustrating another example taken along line III-III' of FIG. 3.

In another embodiment, as illustrated in FIG. 9, the thickness of each of the protrusions PRT may be less than the thickness of the second inorganic encapsulation layer 146. In this case, the bottom surface of the groove GV may be a portion of the second inorganic encapsulation layer 146 extending to the second peripheral area PA2.

However, the thickness of each of the protrusions PRT illustrated in FIGS. 6 and 9 are examples and embodiments are not limited thereto. As described herein, the thickness of each of the protrusions PRT may be variously modified within a range such that the pattern part PP does not expose the conductive layer that can be disposed below the pattern part PP.

Referring again to FIGS. 3 and 6, a first virtual line VL1 and a second virtual line VL2 may be defined in the second peripheral area PA2 of the display panel 100.

The first virtual line VL1 may be spaced apart from the display area DA in the outward direction. For example, the first virtual line VL1 may be adjacent to a corner of the display area DA and may have a ' ┌' shape in a plan view.

The second virtual line VL2 may be spaced apart from the first virtual line VL1 in the outward direction. For example, the second virtual line VL2 may be adjacent to a corner of the substrate 110 and may have a ' ┌' shape in a plan view.

The pattern part PP may be continuously disposed from the first virtual line VL1 to the second virtual line VL2 defined on the second peripheral area PA2. In other words, a space where the portion of the upper portion of the insulating structure overlapping an area between the first virtual line VL1 and the second virtual line VL2 is removed by etching may be defined as the groove GV, and remaining portions of the insulating structure where the upper portion is not removed may be defined as the protrusions PRT.

In an embodiment, as illustrated in FIG. 6, the first virtual line VL1 may be positioned between the display area DA and the first dam part 162. The second virtual line VL2 may be spaced apart from the crack prevention part 172 in the outward direction. In this case, the pattern part PP may overlap the first dam part 162, the second dam part 164, the crack prevention part 172, and the cover layer 174. Upper surfaces of at least some of the protrusions PRT may have different levels. The bottom surface of the groove GV may have various levels depending on position.

In an embodiment, although not illustrated in the drawing, the first virtual line VL1 may be positioned between the second dam part 164 and the crack prevention part 172. The second virtual line VL2 may be spaced apart from the crack prevention part 172 in the outward direction. In this case, the pattern part PP may overlap the crack prevention part 172 and the cover layer 174, and may not overlap the first dam part 162 and the second dam part 164. Upper surfaces of at least some of the protrusions PRT may have different levels. That is, for example, respective upper surfaces of at least some of the protrusions PRT may be of different heights compared to one another. The bottom surface of the groove GV may have various levels depending on position. For example, some portions of the bottom surface of the groove GV may be substantially uneven with respect to one another.

In an embodiment, although not illustrated in the drawing, the first virtual line VL1 may be positioned outside the crack prevention part 172. The second virtual line VL2 may be positioned outside the first virtual line VL1. In this case, the pattern part PP may not overlap the first dam part 162, the second dam part 164, the crack prevention part 172, and the cover layer 174. Upper surfaces of the protrusions PRT may have substantially the same level. That is, for example, respective upper surfaces of the protrusions PRT may be of the same height compared to one another. The bottom surface of the groove GV may have a substantially constant level. For example, the bottom surface of the groove GV may be substantially flat.

In an embodiment, as illustrated in FIG. 6, the second virtual line VL2 may be positioned at the edge 110e of the substrate 110. In this case, the pattern part PP may adjoin the edge 110e of the substrate 110. In some aspects, as illustrated in FIG. 6, the pattern part PP may overlap the edge 110e of the substrate 110.

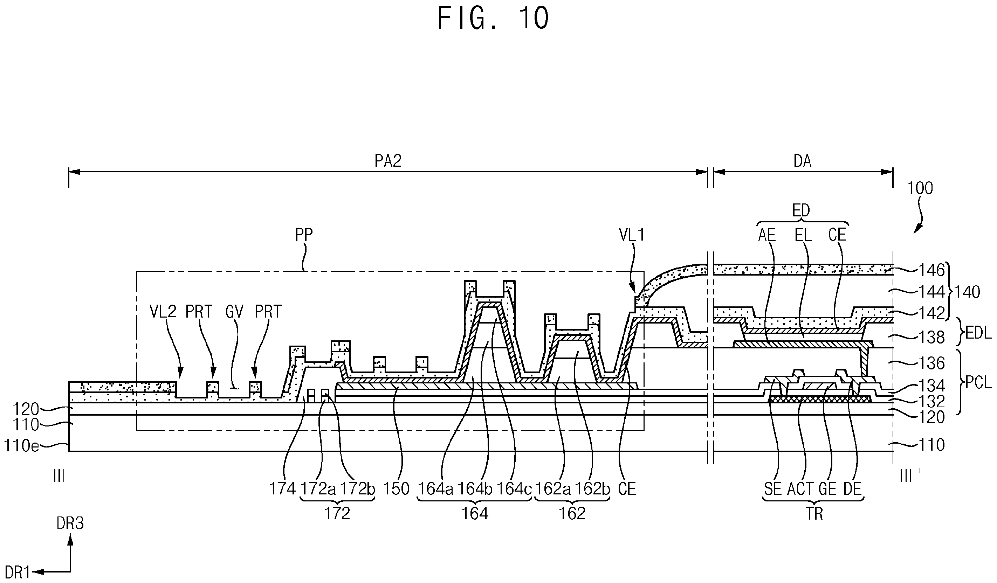

FIG. 10 is a cross-sectional view illustrating still another example taken along line III-III' of FIG. 3.

In an embodiment, as illustrated in FIG. 10, the second virtual line VL2 may be spaced apart from the edge 110e of the substrate 110 in an inward direction. In this case, the pattern part PP may be spaced from the edge 110e of the substrate 110 in the inward direction.

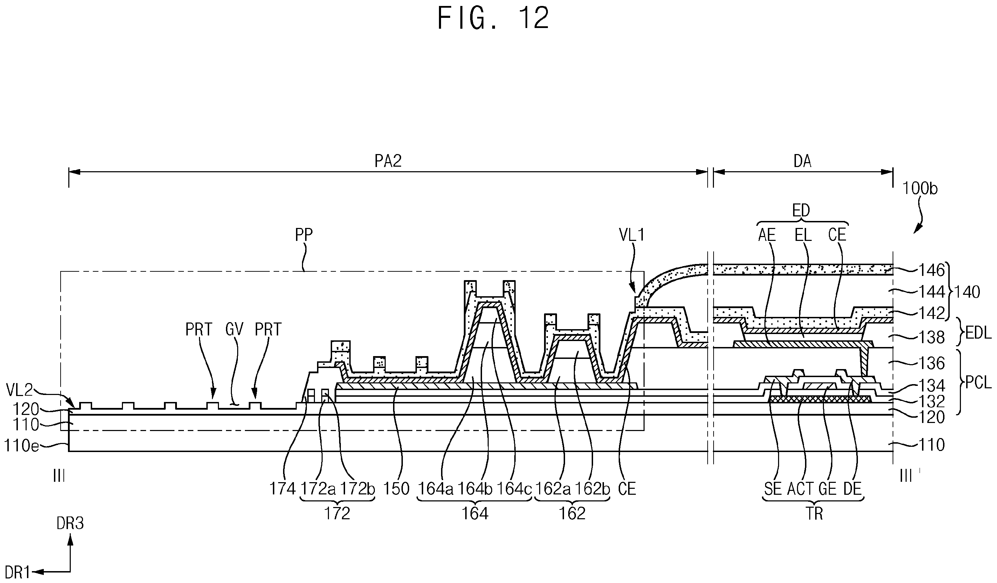

FIGS. 11 and 12 are cross-sectional views illustrating a display panel according to an embodiment.

Hereinafter, a display panel 100b of FIGS. 11 and 12 will be described focusing on differences from the display panel 100 described with reference to FIGS. 6 and 7, and any repetitive detailed descriptions of the same or like element as those described herein may be omitted or simplified.

FIG. 11 may correspond to FIG. 5, and FIG. 12 may correspond to FIG. 6. For example, FIG. 11 may illustrate a portion of the second peripheral area PA2 where the pattern part PP is not disposed, and FIG. 12 may illustrate a portion of the second peripheral area PA2 where the pattern part PP is disposed.

Referring to FIG. 11, at least one insulating layer among the insulating layers included in the pixel circuit layer PCL and the inorganic encapsulation layers included in the encapsulation layer 140 may extend from the display area DA to the peripheral area PA including the second peripheral area PA2. For example, the buffer layer 120 may extend to the edge 110e of the substrate 110, and the gate insulating layer 132, the interlayer insulating layer 134, the first inorganic encapsulation layer 142, and the second inorganic encapsulation layer 146 may extend to the crack prevention part 172 between the display area DA and the edge 110e of the substrate 110. For example, the cover layer 174 may cover an edge of the gate insulating layer 132 and an edge of the interlayer insulating layer 134. An edge of the first inorganic encapsulation layer 142 and an edge of the second inorganic encapsulation layer 146 may be disposed on the cover layer 174. A portion of an upper surface of the cover layer 174 may be exposed and not covered by the first and second inorganic encapsulation layers 142 and 146.

Referring to FIG. 12, the pattern part PP may be disposed in a portion of the second peripheral area PA2 on the substrate 110. The pattern part PP is a structure whose upper surface has an uneven structure.

The pattern part PP may be formed by partially removing at least one insulating layer extending to the second peripheral area PA2. In other words, an upper portion of the insulating structure positioned in the second peripheral area PA2 and including at least one insulating layer may be partially removed, and a portion of the insulating structure whose upper surface has an uneven structure by the partially removing may be defined as the pattern part PP.

A space where the portion of the upper portion of the insulating structure positioned in the second peripheral area PA2 is removed may be defined as the groove GV, and remaining portions of the insulating structure where the upper portion is not removed may be defined as the protrusions PRT. For example, portions of upper portions of different insulating layers may be removed to define the groove GV depending on position. For example, at least some of the protrusions PRT may include different insulating layers. For example, the bottom surface of the groove GV may be a portion of each of the different insulating layers depending on position.

In an area between the first virtual line VL1 and the edges of the first and second inorganic encapsulation layers 142 and 146, respective portions of upper portions of the first and second inorganic encapsulation layers 142 and 146 may be removed to define the groove GV The bottom surface of the groove GV may be a portion of the first inorganic encapsulation layer 142.

In an area between the edges of the first and second inorganic encapsulation layers 142 and 146 and an outer edge of the cover layer 174, a portion of an upper portion of the cover layer 174 may be removed to define the groove GV The bottom surface of the groove GV may be a portion of the cover layer 174.

In an area between the outer edge of the cover layer 174 and the second virtual line VL2, a portion of an upper portion of the buffer layer 120 may be removed to define the groove GV The bottom surface of the groove GV may be a portion of the buffer layer 120.

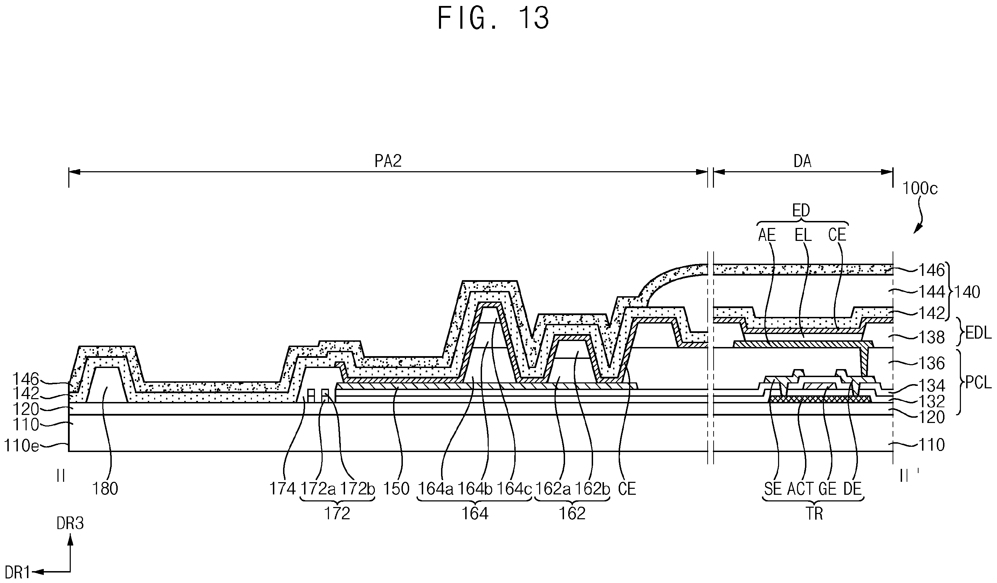

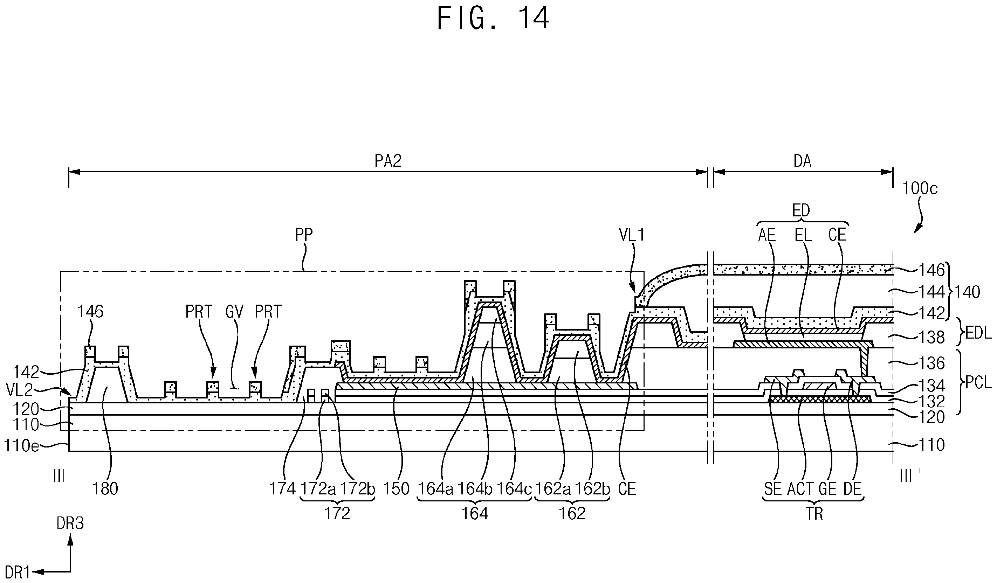

FIGS. 13 and 14 are cross-sectional views illustrating a display panel according to an embodiment.

Hereinafter, a display panel 100c of FIGS. 13 and 14 will be described focusing on differences from the display panel 100 described with reference to FIGS. 6 and 7, and any repetitive detailed descriptions of the same or like element as those described herein may be omitted or simplified.

FIG. 13 may correspond to FIG. 5, and FIG. 14 may correspond to FIG. 6. For example, FIG. 13 may illustrate a portion of the second peripheral area PA2 where the pattern part PP is not disposed, and FIG. 14 may illustrate a portion of the second peripheral area PA2 where the pattern part PP is disposed.

Referring to FIGS. 13 and 14, the display panel 100c may further include a third dam part 180 disposed in the second peripheral area PA2.

The third dam part 180 may be disposed in the second peripheral area PA2 on the substrate 110. The third dam part 180 may be spaced apart from the crack prevention part 172 in the outward direction. The third dam part 180 may be disposed adjacent to the edge 110e of the substrate 110. For example, the third dam part 180 may be substantially simultaneously formed with the via insulating layer 136 or the pixel defining layer 138 of the display area DA. The third dam part 180 may prevent the protective layer resin from overflowing.

In an embodiment, the first inorganic encapsulation layer 142 and the second inorganic encapsulation layer 146 may cover the third dam part 180. In another embodiment, the first inorganic encapsulation layer 142 and the second inorganic encapsulation layer 146 may extend to the inside surface of the third dam part 180 (e.g., up to the right surface of the third dam part 180 in FIGS. 13 and 14) and may not cover the third dam part 180.

The second virtual line VL2 may be defined outside the third dam part 180. In this case, the pattern part PP may overlap the third dam part 180. That is, the pattern part PP having the protrusions PRT and the groove GV may be disposed also on the third dam part 180. Accordingly, the protective layer can be easily removed from the display panel 100c.

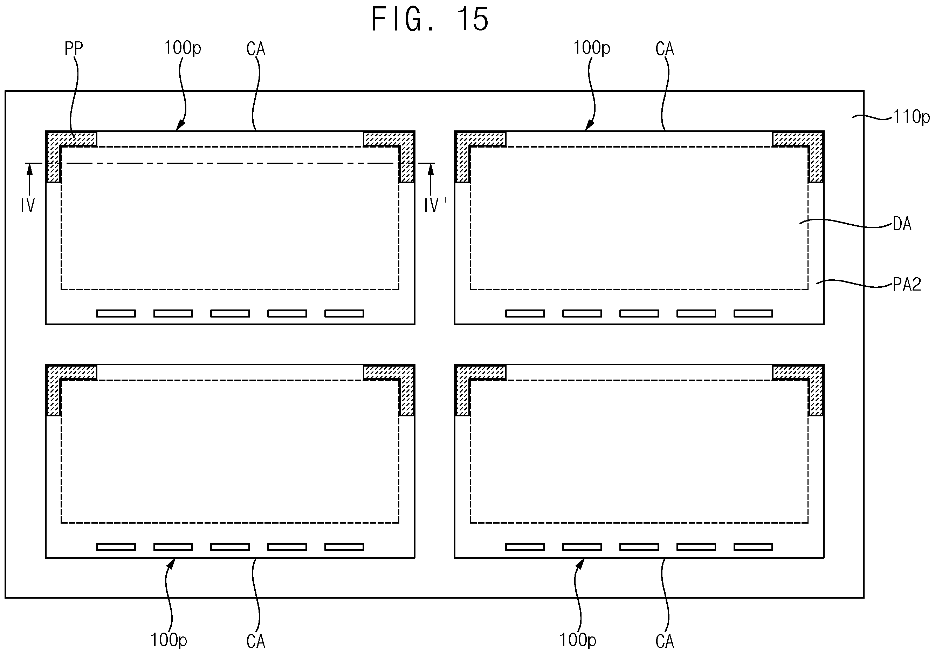

FIGS. 15 to 21 are views illustrating a method of manufacturing a display device according to an embodiment.

Hereinafter, a manufacturing method of the display device 10 described with reference to FIGS. 1 to 14 will be described with reference to FIGS. 15 to 21, and any repetitive detailed descriptions of the same or like element as those described herein may be omitted or simplified.

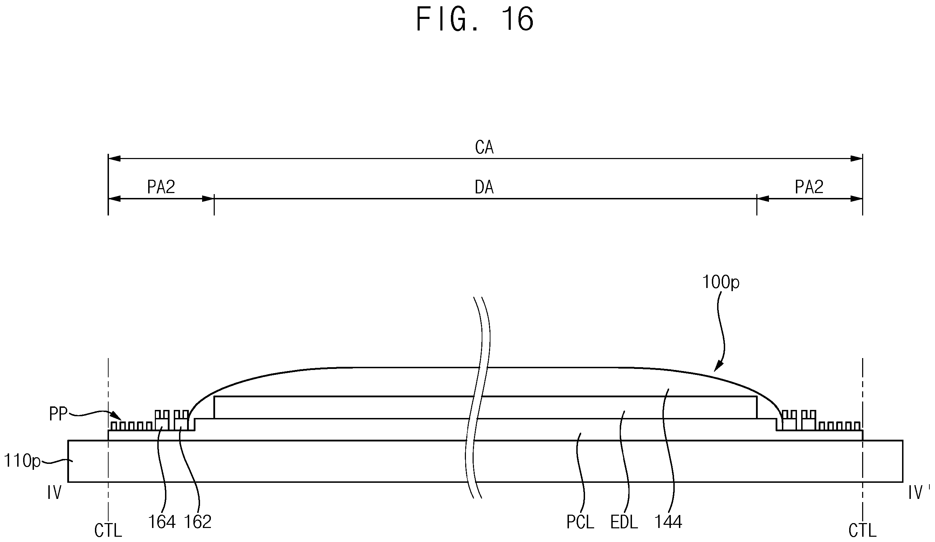

FIG. 15 is a plan view illustrating a mother substrate 110p on which a plurality of preliminary display panels 100p are formed. Each of the preliminary display panels 100p illustrated in FIG. 15 may correspond to one of the display panels 100, 100b, and 100c described with reference to FIGS. 1 to 14. FIGS. 16 to 21 are cross-sectional views illustrating a process from forming a protective layer PT on each of the preliminary display panels 100p to removing the protective layer PT. Each of FIGS. 16 to 21 may correspond to a cross-sectional view taken along line IV-IV' of FIG. 15.

Referring to FIGS. 15 to 21, first, the method may include forming the plurality of preliminary display panels 100p on the mother substrate 110P. The mother substrate 110P may include a plurality of cell areas CA spaced apart from each other. Each of the cell areas CA may include the display area DA, the peripheral area positioned outside the display area DA, and the pad area positioned outside the display area DA. The peripheral area may include the first peripheral area PA1 (not labeled) between the display area DA and the pad area PDA (not labeled), and the second peripheral area PA2 excluding the first peripheral area. The preliminary display panels 100p may be formed in the cell areas CA on the mother substrate 110p, respectively.

The method may include forming the pixel circuit layer PCL, the light emitting element layer EDL, and the encapsulation layer 140 of FIG. 5 in the display area DA included in each of the cell areas CA. The organic encapsulation layer 144 included in the encapsulation layer 140 may cover the entire display area DA. The method may include forming the power transmission line 150, the first dam part 162, the second dam part 164, and the crack prevention part 172 of FIG. 5 in the peripheral area included in each of the cell areas CA. At least one insulating layer among the insulating layers included in the pixel circuit layer PCL and at least one inorganic encapsulation layer included in the encapsulation layer 140 may extend from the display area DA to the peripheral area including the second peripheral area PA2.

Subsequently, the method may include forming the pattern part PP whose upper surface has an uneven structure in the second peripheral area PA2 included in each of the cell areas CA. The pattern part PP may have the protrusions PRT and the groove GV defining the protrusions PRT.

The method may include forming the pattern part PP by partially removing an insulating structure including the at least one insulating layer in the second peripheral area PA2. In other words, in the second peripheral area PA2, a portion of the insulating structure whose upper surface has an uneven structure by the partially removing may be defined as the pattern part PP. For example, a space where a portion of an upper portion of the insulating structure is removed may be defined as the groove GV, and remaining portions of the insulating structure where the upper portion is not removed may be defined as the protrusions PRT.

The pixel circuit layer PCL, the light emitting element layer EDL, the encapsulation layer 140, the power transmission line 150, the first dam part 162, the second dam part 164, the crack prevention part 172, and the pattern part PP formed in each of the cell areas CA on the mother substrate 110p may constitute each of the preliminary display panels 100p.

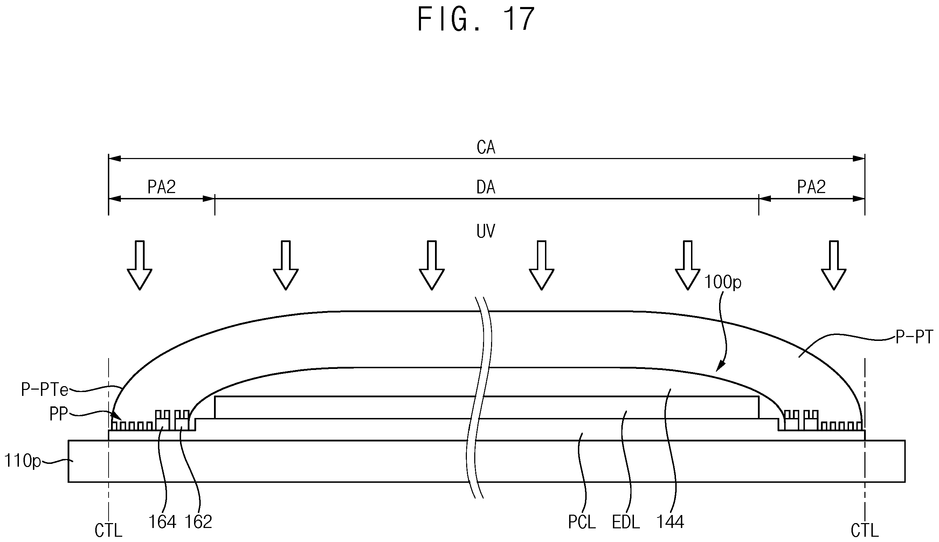

Subsequently, the method may include forming the protective layer PT on each of the cell areas CA. First, as illustrated in FIG. 17, the method may include providing a protective layer resin P-PT on each of the cell areas CA. The protective layer resin P-PT may be provided on the encapsulation layer 140 and the pattern part PP formed in each of the cell areas CA.

The method may include providing the protective layer resin P-PT on each of the cell areas CA in a liquid form. For example, the method may include providing the protective layer resin P-PT by inkjet printing, coating or the like. In an example, the protective layer resin P-PT may include acryl-based resin, but this is an example and embodiments are not limited thereto. The protective layer resin P-PT may be provided to cover the entire organic encapsulation layer 144. For example, the protective layer resin P-PT cover the entire organic encapsulation layer 144.

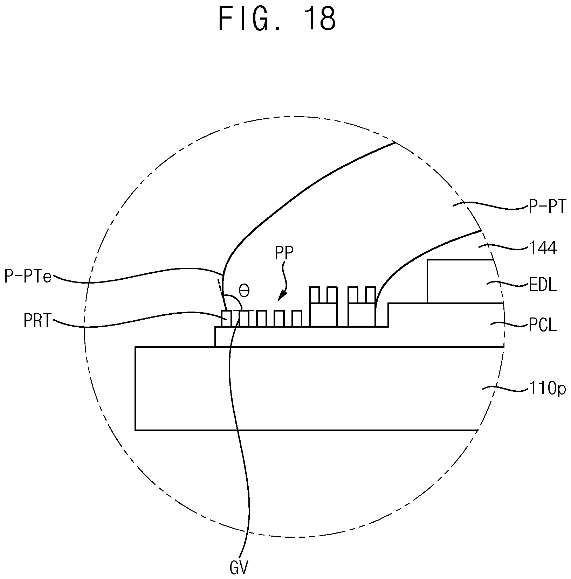

As illustrated in FIG. 18, the protective layer resin P-PT may be provided such that an edge P-PTe of the protective layer resin P-PT is positioned on the pattern part PP. In some aspects, providing the protective layer resin P-PT such that the edge P-PTe is positioned on the pattern part PP whose upper surface has an uneven structure supports increasing a contact angle θ of the protective layer resin P-PT. The contact angle θ of the protective layer resin P-PT may be defined as an angle between an upper surface of the protrusion PRT in contact with the edge P-PTe and a tangent line of the edge P-PTe. For example, the contact angle θ of the protective layer resin P-PT may be greater than or equal to about 90°. Compared to the comparative example in which the pattern part PP is not formed, the protective layer resin P-PT may be formed to have a relatively thick edge portion.

In an area where the pattern part PP is not disposed, the edge P-PTe of the protective layer resin P-PT may be positioned on an upper surface of the at least one insulating layer extending to the peripheral area, or the edge P-PTe of the protective layer resin P-PT may be positioned on an upper surface of the mother substrate 110p.

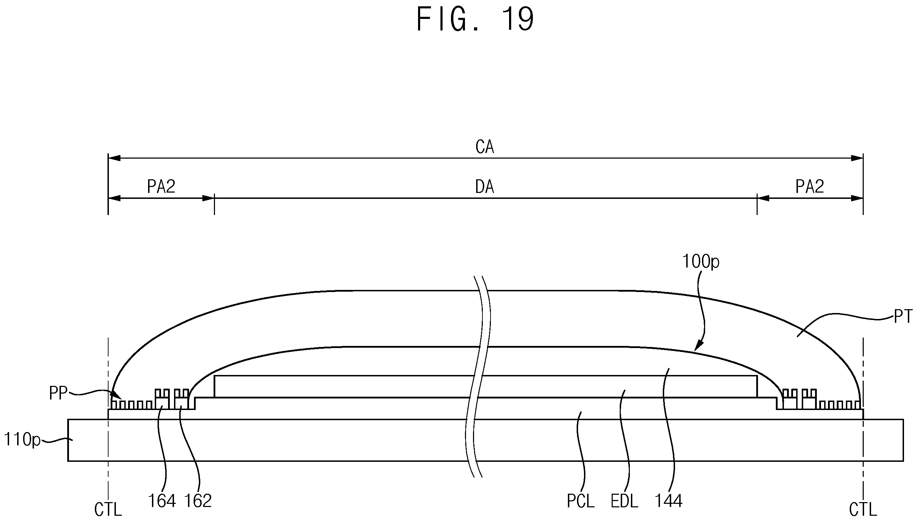

Subsequently, as illustrated in FIGS. 17 and 19, the method may include curing the protective layer resin P-PT to form the protective layer PT. For example, the method may include emitting ultraviolet light UV toward the protective layer resin P-PT from the top of the protective layer resin P-PT, exposing the protective layer resin P-PT to the ultraviolet light UV. The curing of the protective layer resin P-PT by the ultraviolet light UV may form the protective layer PT.

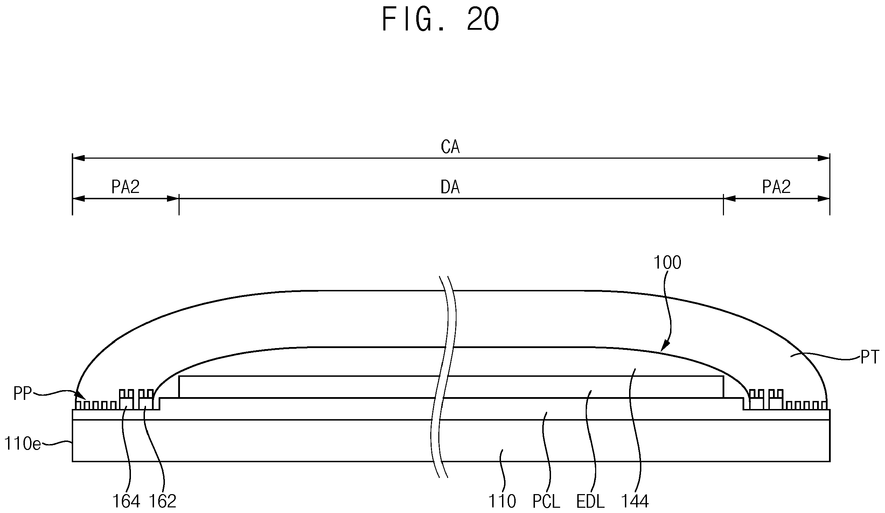

Subsequently, as illustrated in FIGS. 19 and 20, the method may include cutting with respect to each of the cell areas CA of the mother substrate 110p to obtain the display panels 100. A cutting line CTL may be defined along an edge of each of the cell areas CA. The protective layer PT may protect various structures formed in the cell area CA on the mother substrate 110p, such as, for example, pixel circuits, light emitting elements, and wirings, during the cutting process. Each of the preliminary display panels 100p separated by the cutting process may be a display panel 100. Immediately after the cutting process, the protective layer PT may remain on each of the display panels 100.

Subsequently, the method may include removing the protective layer PT from each cut display panel 100. For example, the method may include removing the protective layer PT using a detachment device (not illustrated). In an example, the detachment device may be a knife including an edge portion, which is inserted between the upper surface of the pattern part PP and a lower surface of the protective layer PT, but this is an example and embodiments are not limited thereto.

As described herein, providing the protective layer resin P-PT such that the edge P-PTe is positioned on the pattern part PP whose upper surface has an uneven structure supports increasing the contact angle θ of the protective layer resin P-PT. The protective layer PT may be formed by curing the protective layer resin P-PT. That is, compared to the comparative example in which the pattern part PP is not formed, the protective layer PT may be formed to have a relatively thick edge portion, and thus the protective layer PT can be easily removed from the display panel 100. Accordingly, embodiments of the present disclosure support preventing the protective layer PT from remaining on the display panel 100 or reducing the amount of the protective layer PT which remains on the display panel 100, and the reliability of the display device 10 may be improved.

The method may include providing an anti-reflection member (the anti-reflection member 200 of FIG. 1), a cover window, or the like on each of the display panels 100 from which the protective layer PT has been removed. The display panel 100, the anti-reflection member, and the cover window may constitute the display device 10.

Although embodiments and implementations have been described herein, other embodiments and modifications will be apparent from this description. Accordingly, the example aspects of the present disclosure are not limited to such embodiments, but rather to the broader scope of the appended claims and various obvious modifications and equivalent arrangements as would be apparent to a person of ordinary skill in the art.

## Claims

1. A display device comprising:
a substrate comprising a display area and a peripheral area outside the display area;
a pixel circuit layer disposed in the display area on the substrate and comprising a thin film transistor and a plurality of insulating layers;
a light emitting element layer disposed in the display area on the substrate and comprising a light emitting element electrically connected to the thin film transistor;
an encapsulation layer disposed on the light emitting element layer; and
a pattern part disposed in a portion of the peripheral area on the substrate, wherein an upper surface of the pattern part has an uneven structure.

2. The display device of claim 1, wherein the pattern part comprises a plurality of protrusions spaced apart from each other and a groove defining the plurality of protrusions.

3. The display device of claim 2, wherein a distance between adjacent protrusions among the plurality of protrusions ranges from about 10 µm to about 50 µm.

4. The display device of claim 2 or claim 3, wherein:
(i) each of the protrusions has a rectangular shape in a cross-sectional view; or
(ii) each of the protrusions has a reverse taper shape in a cross-sectional view.

5. The display device of any one of claims 2 to 4, wherein a bottom surface of the groove has an insulating property.

6. The display device of any one of claims 2 to 5, wherein
the light emitting element comprises a pixel electrode, an emission layer, and a common electrode,
the common electrode extends from the display area to the peripheral area, and
a portion of the pattern part overlaps a portion of the common electrode in the peripheral area, optionally wherein in an area where the portion of the pattern part overlaps the portion of the common electrode, a bottom surface of the groove is spaced apart from an upper surface of the common electrode in an upward direction.

7. The display device of any one of claims 2 to 6, wherein
the encapsulation layer comprises a first inorganic encapsulation layer disposed on the light emitting element layer, an organic encapsulation layer disposed on the first inorganic encapsulation layer, and a second inorganic encapsulation layer disposed on the organic encapsulation layer,
at least one insulating layer among the plurality of insulating layers comprised in the pixel circuit layer, the first inorganic encapsulation layer, and the second inorganic encapsulation layer extends from the display area to the peripheral area, and
at least an uppermost layer of the at least one insulating layer defines the groove of the pattern part in the peripheral area.

8. The display device of any one of claims 1 to 7, wherein:
(i) the pattern part is disposed corresponding to a corner portion of the display area; and/or
(ii) the substrate further comprises a pad area positioned at a side of the display area, the peripheral area comprises a first peripheral area between the display area and the pad area and a second peripheral area spaced apart from the pad area, and
the pattern part is disposed in the second peripheral area of the peripheral area.

9. The display device of any one of claims 1 to 8, wherein:
(i) the pattern part adjoins an edge of the substrate; and/or
(ii) the pattern part is continuously disposed from a first virtual line to a second virtual line,
the first virtual line is spaced apart from the display area in an outward direction and is positioned within the peripheral area, and
the second virtual line is positioned at an edge of the substrate.

10. The display device of any one of claims 1 to 9, further comprising a first dam part disposed in the peripheral area on the substrate, spaced apart from the display area in an outward direction, and surrounding the display area, and
wherein the pattern part overlaps the first dam part.

11. The display device of claim 10, further comprising a crack prevention part disposed in the peripheral area on the substrate and spaced apart from the first dam part in the outward direction, and
wherein the pattern part further overlaps the crack prevention part, optionally further comprising a second dam part disposed in the peripheral area on the substrate and spaced apart from the crack prevention part in the outward direction, and
wherein the pattern part further overlaps the second dam part.

12. The display device of any one of claims 1 to 11, further comprising an anti-reflection member disposed on the encapsulation layer.

13. A method of manufacturing a display device, the method comprising:
forming a pixel circuit layer, a light emitting element layer, and an encapsulation layer on a mother substrate comprising a plurality of cell areas, wherein each of the cell areas comprises a display area and a peripheral area outside the display area;
forming a pattern part in the peripheral area of each of the cell areas, wherein an upper surface of the pattern part has an uneven structure;
forming a protective layer by providing a protective layer resin on the encapsulation layer and the pattern part of each of the cell areas;
obtaining a plurality of display panels by cutting along cutting lines defined along edges of each of the cell areas; and
removing the protective layer from each of the display panels.

14. The method of claim 13, wherein
at least one insulating layer among a plurality of insulating layers comprised in the pixel circuit layer and at least one inorganic encapsulation layer comprised in the encapsulation layer extends from the display area to the peripheral area, and
the forming the pattern part comprises forming a plurality of protrusions and a groove defining the plurality of protrusions by partially etching the at least one insulating layer in the peripheral area.

15. The method of claim 13 or claim 14, wherein:
(i) the forming the protective layer comprises curing the protective layer resin by exposing the provided protective layer resin to ultraviolet light; and/or
(ii) the forming the protective layer comprises providing the protective layer resin such that an edge of the protective layer resin is positioned on the pattern part; and/or
(iii) the method further comprises providing an anti-reflection member on each of the display panels from which the protective layer has been removed.
